# EUROPEAN PATENT APPLICATION

(11) **EP 2 600 704 A1**
(43) Date of publication of application: **05.06.2013**
(21) Application number: 11405364.8
(22) Date of filing: 02.12.2011
(51) Int. Cl.: H05K 5/02

(54) **Multifunctional changing device**

(71) Applicant: DET International Holding Limited, George Town, Grand Cayman (KY)
(72) Inventor: Schlenker, Arnold, 79341 Kenzingen (DE); Langenbacher, Patrick, 79602 Breisach (DE); Walliser, Dietmar, 79312 Emmendingen (DE)
(74) Representative: Stäbler, Roman

(57) **Abstract**

Disclosed is a changing device (D1, D2, D3, D4) for insertion and removal of a component into and out of a power electronics gear, in particular an inverter, wherein a wall (W) of a housing of the power electronics gear comprises an opening fitted to receive the changing device (D1, D2, D3, D4) and wherein the changing device (D1, D2, D3, D4) comprises a plug-in board (1).

## Description

### Technical Field

The invention relates to a changing device for a power electronics gear, in particular an inverter, according to the preamble of claim 1 as well as to a power electronics gear according to claim 16.

### Background Art

Electrical devices and in particular inverters typically comprise certain components which need to be replaced from time to time. Such components can for example be batteries (such as batteries for real-time clocks for example) or wear parts (such as connections for example). The inverters that are known up to now have the disadvantage that they have to be opened up for replacing such components like batteries or wear parts. In particular, screws typically have to be removed for opening the inverters. This can be a severe disadvantage, in particular in humid, dusky or other extreme environments. Another disadvantage of the fact that inverters have to be opened up and closed by removing/replacing screws in order to replace certain components is that this procedure can be considerably time-consuming. However, outage time due to maintenance must be minimized in many power electronic applications.

### Summary of the invention

It is the object of the invention to create a changing device pertaining to the technical field initially mentioned, that resolves or at least reduces the above-mentioned disadvantages. In particular, it is the object of the invention to create a changing device that allows easy and quick removal and/or replacement of components such as batteries or wear parts in power electronic gear such as, for example, inverters.

The solution of the invention is specified by the features of claim 1. According to the invention, a changing device for insertion and removal of a component, in particular an electrical component, into a power electronics gear, in particular an inverter, wherein a wall of a housing of the power electronics gear comprises an opening fitted to receive the changing device, comprises a removable plug-in board. For example, such a plug-in board can be an electronic circuit board, typically fitted to carry technical, preferably electronic equipment.

The invention has the advantage that it makes an easy and quick removal and/or replacement of components such as batteries or wear parts in power electronic gear such as inverters possible.

In a preferred embodiment, the plug-in board comprises a battery fitting and/or a battery box or battery case or battery compartment and/or a battery and/or another changing component. The battery fitting is typically configured to receive a real-time battery, preferably a coin cell battery or a button cell battery. A battery fitting and/or a battery on the plug-in board has the advantage that the battery can be easily replaced by removing the plug-in board from the changing device and thus from the power electronic gear, replacing the battery on the plug-in board and then replacing the plug-in board in the changing device.

In a preferred embodiment, the plug-in board and/or the changing device comprise(s) a USB connection and/or an RJ45 connection and/or an I/O connection and/or another - preferably electric or electronic - connection.

In a preferred embodiment, the changing device comprises a fixture configured to receive the plug-in board. Such a fixture of the changing device is typically securely fastened to the power electronics gear, in particular to its housing. The plug-in board can typically be inserted in the fixture and/or be removed from the fixture. The use of such a fixture has the advantage that a changing process can be simplified through minimization of components that need to be removed during this process.

The fixture preferably comprises an insertion guidance for receiving the plug-in board. The insertion guidance is typically formed by two rail elements on opposite sides of the fixture. Such an insertion guidance has the advantage to allow a quick, easy and controlled movement of the plug-in board in the fixture.

In typical embodiments, the fixture comprises a connector fitting for receiving an electric connector. This connector typically comprises connection holes on a front side and a back side, wherein the connection holes of the back side are connected to cables that connect the connector to an internal circuit of the power electronics gear and wherein the connection holes of the front side are configured to receive connecting pins of the plug-in board. The connector is thus configured to establish a connection between the plug-in board and the circuit of the inverter. The connector fitting typically comprises at least one clip for fastening the connector in the connector fitting.

The fixture typically comprises a first thread for fixing and/or securing the fixture in the opening of the wall of the housing of the power electronics gear. Preferably, the first thread is configured in such a way that it can be inserted into the opening, preferably without touching the wall of the housing, and that it can at least partially be plunged through the opening such that at least a part of the first thread extends into an interior of the power electronics gear. The first thread is preferably designed such that a nut, preferably a ring nut, can be screwed onto the first thread from the interior of the power electronics gear in order to fix and/or secure and/or fasten the fixture in/to the wall of the housing and/or the opening.

The fixture typically comprises a cover ring for covering a remaining gap between the first thread and the opening when the changing device is secured in the opening. This cover ring is typically also configured to act as a blocking arrestor for blocking the insertion of the fitting and/or the first thread into the opening at a certain position. The cover ring is preferably configured to assure a proper fixing of the fixture in the wall in combination with the nut.

The changing device preferably comprises a cap for protecting the changing device for example against humidity or dusk. The cap typically comprises two parts, wherein at least one part comprises a cap thread, preferably an internal cap thread.

In preferred embodiments, the fixture comprises a second thread for screwing the cap onto the fixture. Alternatively, it is also possible that the fixture is configured in such a way that the cap can be hoisted onto the fixture. The cap is preferably large enough to offer sufficient space for a USB-stick, preferably mini USB-stick with length of less than 20 mm, preferably less than 15 mm, when the cap is securely fastened to the fixture. This has the advantage that a USB-stick can be connected to the USB connector of the plug-in board in order to log data of the inverter while being covered and protected by the cap.

In a preferred embodiment, the changing device comprises a connecting means, in particular a connecting strip, for connecting the cap to the fixture and/or the housing. Like this, the cap cannot be lost when removed from and/or screwed off the fixture.

The connecting means typically comprises a first substantially round opening for receiving and/or enlacing the cap at least partially and/or a second substantially round opening for receiving and/or enlacing the fixture at least partially, preferably between the cover ring and the first thread. The second opening is typically configured to be clamped between the cover ring and the wall of the housing. This ensures a safe connection between the cap and the fixture and/or power electronic gear.

The changing device preferably comprises a cover plate for covering an opening between the fixture and the fixture-mounted plug-in board, preferably an opening between the fixture and the fixture-mounted plug-in board and/or the USB connection and/or the RJ45 connection and/or the I/O connection and/or another technical component mounted on the plug-in board. The cover plate typically has an outer outline that fits into an inner outline of the fixture and/or an inner outline of the second thread. The cover plate typically comprises a clipping fin configured to allow an easy mounting of the cover plate in the fixture.

In a preferred embodiment, the changing device comprises a seal for sealing a contact region between the fixture and the cap when the cap is mounted on the fixture and/or between the fixture and another component that is mounted on the fixture.

In preferred embodiments, the changing device comprises a cable link for linking the power electronics gear to an external device such as a data logger, wherein the cable link comprises a cable cap and/or a cable seal and/or a cable gland. The cable cap is typically an IP 65 cap and/or compliant with IP 65. The cable link does not have to be an integral part of the changing device; it can also be a replacement part, for example for replacing the cap when needed.

A power electronics gear, in particular an inverter, according to the invention typically comprises a changing device according to the invention.

Other advantageous embodiments and combinations of features come out from the detailed description below and the totality of the claims.

### Brief description of the drawings

The drawings used to explain the embodiments show:
- Fig. 1:: a 3D-view of a changing device according to the invention comprising a USB connection;
- Fig. 2:: a 3D-view of a changing device according to the invention comprising an I/O connection;
- Fig. 3:: a 3D-view of a changing device according to the invention comprising an RJ45 connection and
- Fig. 4:: a 3D-view of a changing device according to the invention comprising an I/O connection and a cable link.

In the figures, the same components are given the same reference symbols.

### Preferred embodiments

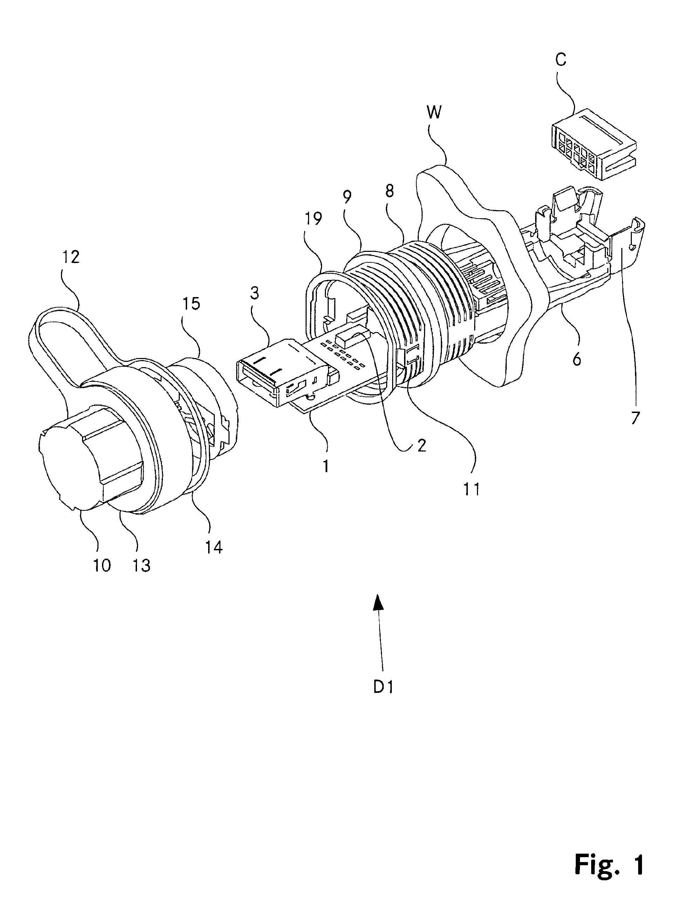

Figure 1 shows a 3D-view of a first embodiment of a changing device D1 according to the invention.

The changing device D1 comprises a plug-in board 1 that can be inserted in and removed from a fixture 6 of the changing device D1. A changing component 2 and a USB connection 3 are mounted on the plug-in board 1. Instead of or in addition to the changing component 2, a battery fitting containing a button cell battery (both not shown) could be mounted on the plug-in board 1.

The fixture 6 can be mounted into an opening in a wall W of an inverter housing. The fixture 6 comprises a connector fitting 7 which is configured to receive and hold an electric connector C. This electric connector C is configured to establish an electric connection between the plug-in board 1 and an inverter circuit (not shown). The fixture 6 further comprises a first external thread 8 for securing the fixture 6 in the opening of the wall W by means of a ring nut (not shown) which is screwed onto the first external thread 8 from an interior of the inverter. The fixture 6 also comprises a cover ring 9. The cover ring 9 separates the first thread 8 from a second external thread 11 of the fixture 6. A cap 10 can be screwed onto this second thread 11 in order to close the entire changing device D1 when mounted in the wall W of the inverter housing. The cap 10 has two parts, namely a small front part and a large back part. Between the large back part and small front part of the cap 10, a connecting means 12 is fixed to the cap 10 by means of a first opening 13. In addition to the first opening 13, the connecting means 12 comprises second opening 14 by which the connecting means 12 and therefore the cap 10 can be fixed to the inverter. This fixing takes place by clamping the second opening 14 between the cover ring 9 and the wall W when securing the fixture 6 in the opening of the wall W.

Figure 1 also shows a cover plate 15 that is configured to close a remaining gap present between the USB connection 3 and the fixture 6 when the plug-in board 1 is completely inserted into the fixture 6. An outer outline of the cover plate 15 is formed as a complement to an inner outline of the second thread 11 such that the cover plate 15 fits tightly into the second thread 11 and/or the fixture 6. When the cover plate 15 is mounted into the fixture 6, only the USB connection 3 protrudes partially through the cover plate 15. The changing device D 1 shown in Figure 1 also shows a seal 19 fixed to an outer rim of the fixture 6. This seal 19 seals a contact region between the cap 10 and the fixture 6 when the cap 10 is screwed onto the second thread 11.

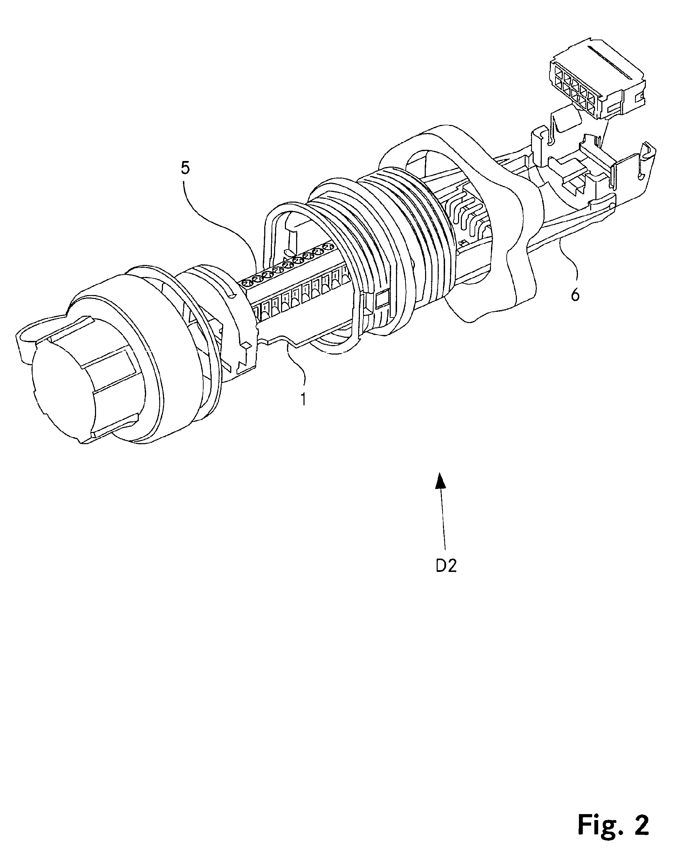

Figure 2 shows a 3D-view of a second embodiment of a changing device D2 according to the invention. The changing device D2 differs from the changing device D 1 shown in Figure 1 in that the plug-in board 1 that can be inserted into the fixture 6 comprises an I/O connection 5 instead of a USB connection 3.

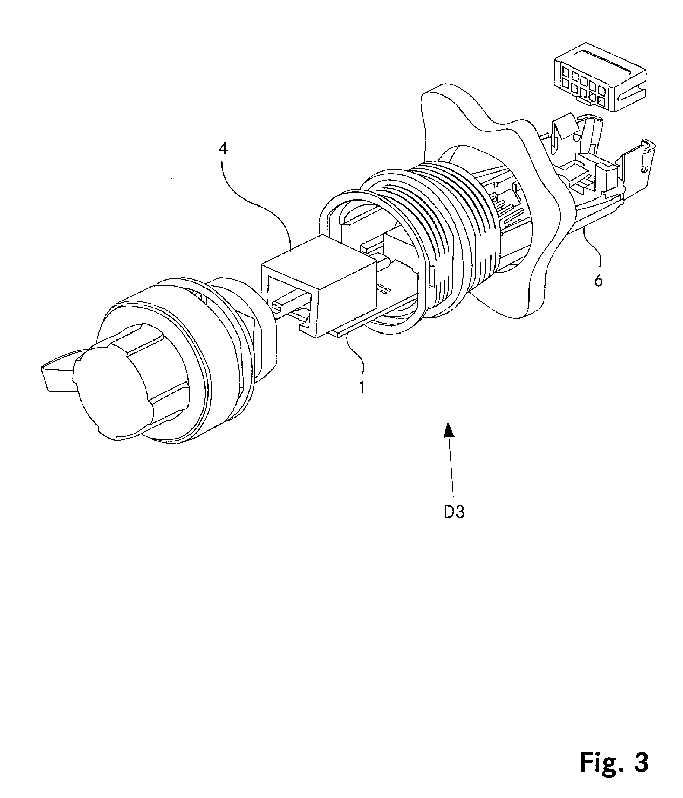

Figure 3 shows a 3D-view of a third embodiment of a changing device D3 according to the invention. The changing device D3 differs from the changing devices D1 and D2 shown in Figure 1 and Figure 2, respectively, in that the plug-in board 1 that can be inserted into the fixture 6 comprises an RJ45 connection 4 instead of a USB connection 3 or an I/O connection 5, respectively.

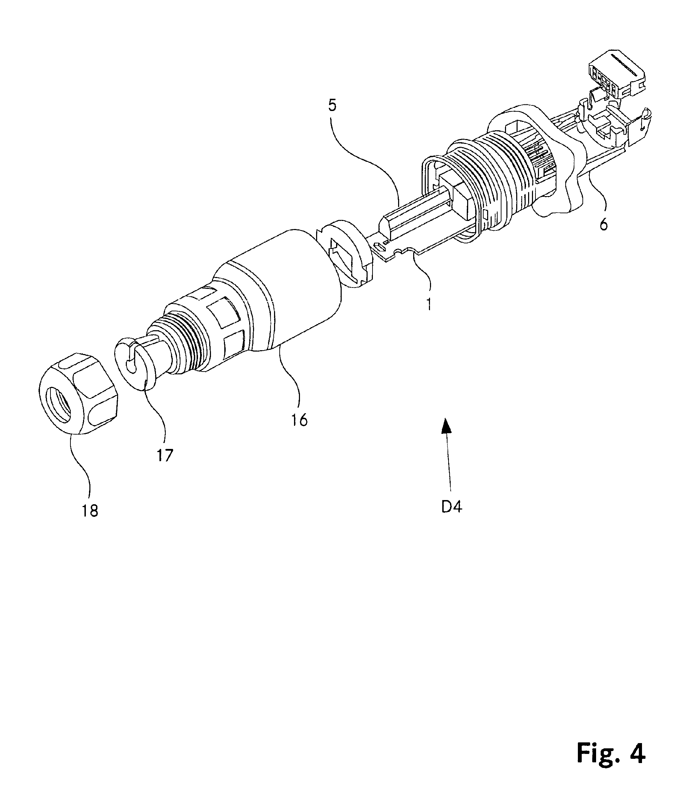

Figure 4 shows a 3D-view of a fourth embodiment of a changing device D4 according to the invention. The changing device D4 differs from the previously described changing devices D1, D2 and D3 in that the changing device D4 comprises a cable link composed of a cable cap 16, a cable seal 17 and a cable gland 18 instead of a cap 10 and a connecting means 12. The fact that the latter are not shown in Figure 4 does, however, not mean that an embodiment of the invention cannot comprise cap 10, connecting means 12 and cable link at the same time: this is rather of course also possible. The cable link shown in Figure 4 can be used to safely connect and seal a cable (not shown) to the changing device D4. Such a cable could, for example, connect the inverter to an external data logger via the I/O connection 5.

The invention is by no means limited to the embodiments described here. The scope of protection is rather defined by the patent claims.

## Claims

1. Changing device (D1, D2, D3, D4) for insertion and removal of a component into and out of a power electronics gear, in particular an inverter, wherein a wall (W) of a housing of the power electronics gear comprises an opening fitted to receive the changing device (D1, D2, D3, D4),
**characterized in that**
the changing device (D1, D2, D3, D4) comprises a plug-in board (1).

2. Changing device (D1, D2, D3, D4) according to claim 1, **characterized in that** the plug-in board (1) comprises a battery fitting and/or a battery and/or another changing component (2).

3. Changing device (D1, D2, D3, D4) according to any of the previous claims, **characterized in that** the plug-in board (1) comprises a USB connection (3) and/or an RJ45 connection (4) and/or an I/O connection (5) and/or another connection.

4. Changing device (D1, D2, D3, D4) according to any of the previous claims, **characterized in that** the changing device (D1, D2, D3, D4) comprises a fixture (6) configured to receive the plug-in board (1).

5. Changing device (D1, D2, D3, D4) according to claim 4, **characterized in that** the fixture (6) comprises an insertion guidance for receiving the plug-in board (1).

6. Changing device (D1, D2, D3, D4) according to any of the claims 4 or 5, **characterized in that** the fixture (6) comprises a connector fitting (7) for receiving an electric connector (C).

7. Changing device (D1, D2, D3, D4) according to any of the claims 4 to 6, **characterized in that** the fixture (6) comprises a first thread (8) for securing the fixture (6) in the opening by means of a nut.

8. Changing device (D1, D2, D3, D4) according to any of the claims 4 to 7, **characterized in that** the fixture (6) comprises a cover ring (9) for covering a remaining gap between the first thread (8) and the opening when the changing device (D1, D2, D3, D4) is secured in the opening.

9. Changing device (D1, D2, D3, D4) according to any of the previous claims, **characterized in that** the changing device (D1, D2, D3, D4) comprises a cap (10) for protecting the changing device (D1, D2, D3, D4).

10. Changing device (D1, D2, D3, D4) according to any of the claims 4 to 9, **characterized in that** the fixture (6) comprises a second threat (11) for screwing the cap (10) onto the fixture (6).

11. Changing device (D1, D2, D3, D4) according to any of the claims 9 or 10, **characterized in that** the changing device (D1, D2, D3, D4) comprises a connecting means (12) for connecting the cap (10) to the fixture (6) and/or the housing.

12. Changing device (D1, D2, D3, D4) according to claim 11, **characterized in that** the connecting means (12) comprises a first substantially round opening (13) for receiving and/or enlacing the cap (10) at least partially and/or a second substantially round opening (14) for receiving and/or enlacing the fixture (6) at least partially, preferably between the cover ring (9) and the first thread (8).

13. Changing device (D1, D2, D3, D4) according to any of the claims 3 or 12, **characterized in that** the changing device (D1, D2, D3, D4) comprises a cover plate (15) for covering an opening between the fixture (6) and the fixture-mounted plug-in board (1).

14. Changing device (D1, D2, D3, D4) according to any of the claims 9 or 13, **characterized in that** the changing device (D1, D2, D3, D4) comprises a seal (19) for sealing a contact region between the fixture (6) and the cap (10) when the cap (10) is mounted on the fixture (6) and/or for sealing a contact region between the fixture (6) and another component that is mounted on the fixture (6).

15. Changing device (D1, D2, D3, D4) according to any of the previous claims, **characterized in that** the changing device (D1, D2, D3, D4) comprises a cable link for linking the power electronics gear with an external device such as a data logger, wherein the cable link comprises a cable cap (16) and/or a cable seal (17) and/or a cable gland (18).

16. Power electronics gear, in particular inverter, **characterized in that** the power electronics gear comprises a changing device (D 1, D2, D3, D4) according to any of the previous claims.
